# FASCICULE DE BREVET EUROPEEN

(11) **EP 3 924 681 B1**
(45) Date de publication et mention de la délivrance du brevet: **30.08.2023**
(21) Numéro de dépôt: 20709649.6
(22) Date de dépôt: 11.02.2020
(51) Int. Cl.: F28F 3/04, F15D 1/00, F28F 13/02, F28F 13/06, F28F 13/12, F28F 13/18, H05K 7/20

(54) **DISSIPATEUR THERMIQUE POUR CARTE ELECTRONIQUE D'UN GROUPE MOTO-VENTILATEUR DE VEHICULE AUTOMOBILE**
KÜHLKÖRPER FÜR EINE ELEKTRONIKKARTE EINER MOTORBETRIEBENEN LÜFTEREINHEIT EINES KRAFTFAHRZEUGS
HEAT SINK FOR AN ELECTRONIC BOARD OF A MOTOR VEHICLE MOTOR-DRIVEN FAN UNIT

(30) Priorité: 12.02.2019 FR 1901364
(43) Date de publication de la demande: 22.12.2021
(73) Titulaire: Valeo Systemes Thermiques, 78320 Le Mesnil-Saint-Denis (FR)
(72) Inventeur: FRANCO, Ismaël, 78320 Le Mesnil Saint-Denis (FR); MA, Zhenxia, 78320 Le Mesnil Saint-Denis (FR)
(74) Mandataire: Valeo Systèmes Thermiques
(86) Numéro de dépôt international: PCT/FR2020/050243
(87) Numéro de publication internationale: WO 2020/165536

(56) Documents cités:
- US-A- 4 449 581
- US-A1- 2010 096 111
- US-B2- 8 230 910

## Description

L'invention concerne dissipateur thermique pour une carte électronique d'un groupe moto-ventilateur de véhicule automobile.

De préférence, un tel groupe moto-ventilateur équipe un dispositif de ventilation, de chauffage et/ou de climatisation du véhicule automobile, qui assure la régulation de la température d'un flux d'air destiné à alimenter l'habitacle du véhicule.

Le groupe moto-ventilateur permet, quant à lui, de faire entrer et circuler le flux d'air dans le dispositif de ventilation, de chauffage et/ou de climatisation jusqu'à des bouches de sortie, où l'air pénètre dans l'habitacle.

Le groupe moto-ventilateur comporte de façon connue un moteur électrique, par exemple à balais, sur lequel est montée une roue pour mettre l'air en mouvement, ainsi qu'un dispositif de commande du moteur électrique, le dispositif de commande du moteur électrique comprenant une carte électronique.

Dans le groupe moto-ventilateur, le dissipateur thermique a pour fonction de refroidir des composants de la carte électronique de commande du moteur, et en particulier des composants haute puissance. De manière classique, le dissipateur thermique se présente sous la forme d'une plaque munie de plots faisant saillie hors de la plaque, la plaque et les plots étant réalisés dans un matériau conducteur thermique. Cette solution présente l'inconvénient d'être encombrante, en raison de la présence des plots. De plus, l'efficacité du refroidissement n'est pas toujours satisfaisante.

US 2010/096111 A1 décrit un dissipateur thermique selon le préambule de la revendication 1.

Le but de l'invention est de fournir un dissipateur thermique possédant un encombrement réduit et une efficacité de refroidissement améliorée.

A cet effet, l'invention a pour objet un dissipateur thermique pour une carte électronique d'un groupe moto-ventilateur de véhicule automobile, comprenant une surface destinée à échanger thermiquement avec un flux d'air mis en mouvement par le groupe moto-ventilateur, dite surface d'échanges, ladite surface d'échanges comprenant une portion plane agencée pour que, dans une position installée dans le groupe moto-ventilateur, le flux d'air mis en mouvement par le groupe moto-ventilateur s'écoule sensiblement parallèlement à ladite portion plane, la surface d'échanges comprenant également un ensemble de cavités non débouchantes affleurant ladite portion plane.

Cette configuration améliore de façon inattendue la convection de l'air contre la surface d'échanges, ce qui permet de rendre plus efficace le refroidissement par le dissipateur thermique. Cette configuration assure la réduction de l'encombrement du dissipateur thermique, ce qui permet aussi d'améliorer l'aéraulique et l'acoustique en réduisant les pertes de charge. (Le dissipateur offrant moins de résistance dans le flux d'air).

Selon une autre caractéristique de l'invention, chaque cavité comprend une partie en forme de pyramide tronquée à base polygonale et/ou une partie de section constante. La section de la partie de section constante est polygonale.

Selon une autre caractéristique de l'invention, la base polygonale est une base hexagonale.

Selon une autre caractéristique de l'invention, les cavités présentent des dimensions identiques.

Selon une autre caractéristique de l'invention, l'ensemble de cavités comporte deux groupes de cavités, les cavités d'un groupe étant identiques entre elles et distinctes des cavités de l'autre groupe.

Selon une autre caractéristique de l'invention, les cavités sont disposées selon un maillage de quadrilatère, par exemple rectangulaire et/ou en quinconce et/ou en nid d'abeille.

Selon une autre caractéristique de l'invention, les cavités possèdent une même orientation.

Selon une autre caractéristique de l'invention, les cavités possèdent une même orientation et une des dimensions identiques.

Selon une autre caractéristique de l'invention, un rapport entre la profondeur d'une cavité et la longueur d'un côté du polygone de la base est compris entre 0,05 et 0,5.

Selon une autre caractéristique de l'invention, un rapport entre une longueur d'un côté de la base polygonale d'une cavité et une distance entre les centres de deux cavités consécutives est compris entre 0,1 et 0,5.

Selon une autre caractéristique de l'invention, l'angle entre la direction d'écoulement du flux d'air et une direction d'une droite joignant deux sommets opposés de la base polygonale est compris entre -15° et 15°.

Selon une autre caractéristique de l'invention, l'angle entre la direction d'écoulement du flux d'air et une direction d'une droite joignant deux sommets opposés de la base polygonale est compris entre 75° et 105°.

Selon une autre caractéristique de l'invention, la surface d'échanges est réalisée dans un matériau en alliage d'aluminium ou en plastique.

L'invention a également pour objet un procédé de fabrication d'un dissipateur thermique tel que décrit précédemment, comprenant une étape de moulage de la portion plane, et une étape d'évidement de la portion plane, de sorte à former l'ensemble de cavités non débouchantes, affleurant la portion plane. Ce procédé en deux étapes successives peut être employé par exemple lorsque le dissipateur thermique est en plastique.

En variante, le procédé de fabrication du dissipateur thermique comprend une étape de moulage permettant d'obtenir directement la surface plane ainsi que l'ensemble de cavités non débouchantes. Il n'est alors pas nécessaire de procéder à une étape ultérieure d'évidement. L'obtention de l'ensemble de cavités par moulage direct est bien adapté à un dissipateur thermique réalisé en alliage d'aluminium.

L'invention a également pour objet un groupe moto-ventilateur pour un véhicule automobile, comprenant un moteur, un ventilateur de mise en mouvement d'un flux d'air configuré pour être contrôlé par le moteur, et un module de commande dudit moteur, le module de commande comportant une carte électronique, le groupe moto-ventilateur comprenant également un dissipateur thermique tel que décrit précédemment agencé pour refroidir ladite carte électronique.

Selon une autre caractéristique de l'invention, les cavités du dissipateur thermique sont disposées en regard d'un composant électronique haute puissance de la carte électronique.

### Brève description des dessins

D'autres caractéristiques, détails et avantages de l'invention apparaîtront à la lecture de la description détaillée ci-après, et à l'analyse des dessins annexés, sur lesquels :
- La figure 1 illustre une vue en perspective d'un dissipateur thermique selon un premier mode de réalisation de l'invention.
- La figure 2 illustre vue en perspective du dissipateur thermique de la figure 1 selon une autre variante.
- La figure 3 illustre une vue en perspective d'un dissipateur thermique selon un deuxième mode de réalisation de l'invention.
- La figure 4 illustre une vue en coupe longitudinale d'une partie d'un groupe moto-ventilateur équipé d'un dissipateur thermique selon la présente invention.
- La figure 5 illustre une vue en perspective du dissipateur thermique de la figure 1 selon un troisième mode de réalisation de l'invention.

### Description des modes de réalisation

L'invention a pour objet un dissipateur thermique pour une carte électronique d'un groupe moto-ventilateur de véhicule automobile. Le dissipateur thermique est référencé 1 sur les figures.

Le groupe moto-ventilateur équipe de préférence un dispositif de ventilation, de chauffage et/ou de climatisation du véhicule automobile.

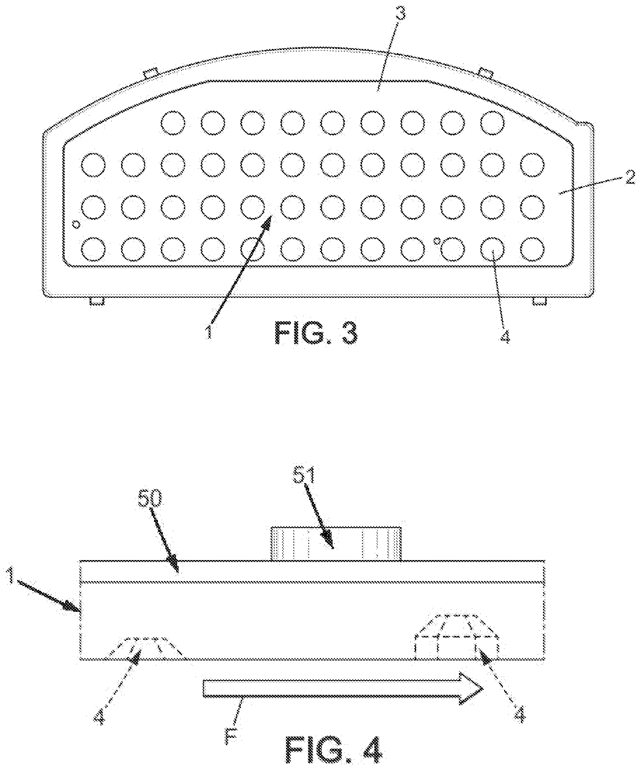

Le groupe moto-ventilateur est agencé pour mettre en mouvement un flux d'air, préférentiellement à destination de l'habitacle du véhicule automobile. Le flux d'air est référencé F sur la figure 4. Sur la figure 4, on a également représenté la carte électronique 50 ainsi qu'un composant électronique haute puissance 51. Le composant peut être un transistor de puissance permettant de commander le moteur électrique du groupe moto-ventilateur. Le transistor peut par exemple être un transistor à effet de champ à grille isolée, couramment désigné par l'acronyme Anglais « Mosfet ».

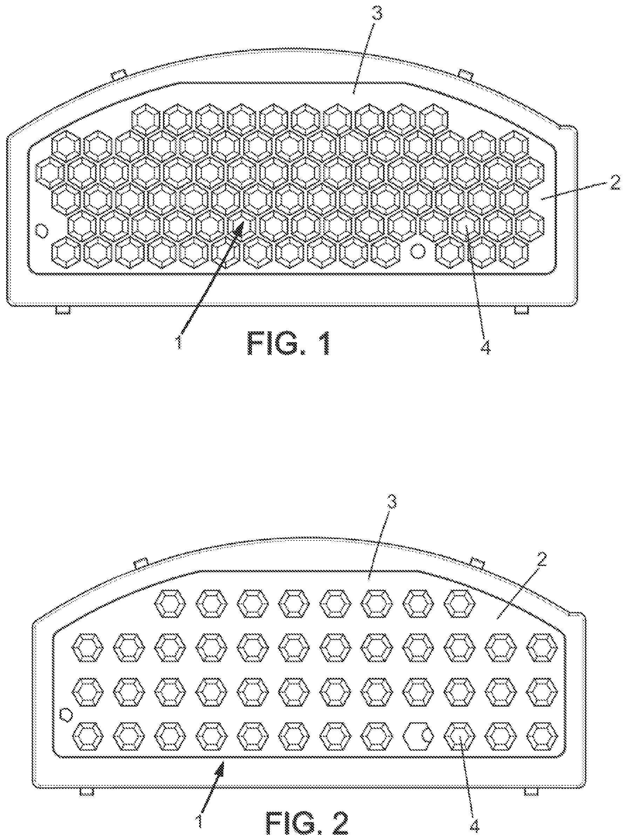

Comme il ressort des figures 1 à 5, le dissipateur thermique 1 comprend une surface 2 destinée à échanger thermiquement avec le flux d'air F, dite surface d'échanges 2. Le flux d'air F échange thermiquement avec la surface 2, notamment par convection, et est ainsi refroidi par la surface d'échanges 2.

Comme illustrée sur les figures 1 à 3, la surface d'échanges 2 comprend une portion plane 3 et un ensemble de cavités 4.

La portion plane 3 est agencée pour que, dans une position où le dissipateur thermique 1 est installé dans le groupe moto-ventilateur, le flux d'air mis en mouvement par le groupe moto-ventilateur s'écoule sensiblement parallèlement à ladite portion plane, comme visible sur la figure 4.

Comme illustrée sur les figures 1 à 3, les cavités 4 affleurent sur la portion plane 3 et sont non débouchantes. La portion plane 3 de la surface 2 est dépourvue d'ajouts de matière pouvant former obstacle au flux d'air F. Autrement dit, la région bordant chaque cavité 4 est plane.

Les cavités 4 peuvent se présenter sous diverses formes maintenant décrites en détails.

Selon un premier mode de réalisation, la forme de l'une ou des cavités 4 comprend une partie en forme de pyramide tronquée à base polygonale : les figures 1 et 2 illustrent des cavités 4 de forme pyramidale tronquée à base hexagonale.

La figure 4 illustre un premier type de cavité en forme de pyramide tronquée et un deuxième type de cavité comprenant (depuis la surface) une première partie de section constante (de 0 à 2 mm de profondeur) puis la partie en forme de pyramide tronquée. La première partie de section constante a une section polygonale. Cette première partie de section constante a donc la forme d'un prisme droit à base polygonale. La partie en forme de pyramide tronquée est raccordée à la partie de section constante et en constitue le prolongement. Chaque génératrice de la partie de section constante rencontre une arête de la partie en forme de pyramide tronquée.

Cette forme pyramidale tronquée à base hexagonale est la forme préférée de la Demanderesse dans la mesure où des simulations et des caractérisations expérimentales ont montré que, de manière surprenante, c'est cette forme qui permet d'obtenir le meilleur compromis entre efficacité du refroidissement procuré par le flux F, bruit généré par l'écoulement du flux d'air F, et pertes de charges engendrées dans le flux d'air F.

Le tableau ci-dessous résume les performances obtenues avec trois formes différentes de cavités. L'échelle utilisée est graduée de 0 à 5, 0 correspondant à la performance la moins bonne et 5 correspondant à la performance la meilleure.

| | Pyramide tronquée à base hexagonale | Demi-sphère | Cube |
|---|---|---|---|
| Refroidissement | 3 | 2 | 4 |
| Niveau de bruit | 4 | 3 | 3 |
| Pertes de charges | 4 | 3 | 3 |

On constate que les cavités en forme de pyramide tronquée à base hexagonale présente le meilleur compromis.

Selon un deuxième mode de réalisation, la forme de l'une ou des cavités 4 est une demi-sphère : la figure 3 illustre cette forme.

Bien entendu, l'invention n'est pas limitée aux modes de réalisation illustrés et d'autres formes peuvent tout à fait être envisagées.

On note que les cavités 4 peuvent être toutes identiques ou au contraire différer les unes des autres, par leur forme et/ou leurs dimensions.

Notamment, les cavités 4 peuvent être réparties selon deux groupes ou plus, les cavités 4 d'un même groupe étant identiques entre elles, et différentes d'un groupe à l'autre.

Les cavités 4 sont distribuées dans la surface d'échanges 2 selon un maillage, dont certains modes de réalisation sont illustrés sur les figures 1 à 3.

Par maillage, on entend que le réseau des cavités 4 est organisé selon un motif donné.

Un premier type de maillage, illustré sur la figure 1, est une structure en nid d'abeilles, c'est-à-dire que les centres des cavités 4 sont alignés selon deux directions formant un angle de 60° entre elles.

Par centre, on entend le point d'intersection des médiatrices des côtés de la base du polygone de la cavité 4.

Un deuxième type de maillage, illustré sur les figures 2 et 3, est de type quadrilatère, c'est-à-dire que les centres des cavités 4 sont alignés selon deux directions orthogonales entre elles.

Un autre type de maillage, non illustré, est une structure en quinconce, c'est-à-dire que les centres des cavités 4 sont alignés selon deux directions formant un angle de 45° entre elles.

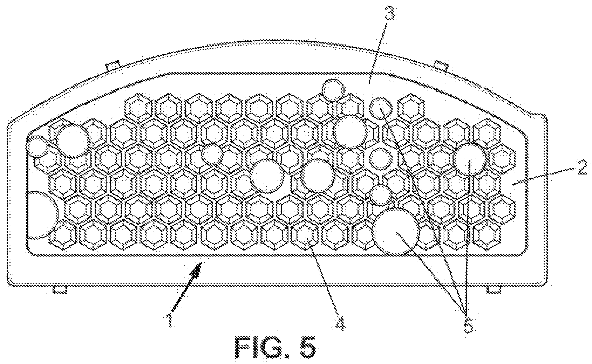

Sur la figure 5, le dissipateur thermique 1 est également muni de plots 5 faisant saillie hors de la surface 2 pour évacuer la chaleur produite par les composants. La répartition des plots 5 et leurs dimensions dépendent du besoin de dissipation thermique.

On note que le taux d'occupation de l'ensemble des cavités 4, leur espacement, leur profondeur notamment dépendent du niveau de refroidissement souhaité.

Par exemple, pour la variante de la figure 2, l'espacement entre les cavités 4 selon la première direction D1 est de 8 mm et de 8,5 mm selon deuxième direction D2. La profondeur choisie est de 2 mm, voire de 1 mm

Avantageusement, un rapport entre la profondeur d'une cavité 4 et la longueur d'un côté du polygone est compris entre 0,05 et 0,5.

De même, un rapport entre une longueur d'un côté de la base polygonale d'une cavité 4 et une distance entre les centres de deux cavités consécutives est compris entre 0,1 et 0,5.

Sur les modes de réalisation illustrés, les cavités 4 possèdent une même orientation, une translation donnée permettant un passage entre une cavité 4 et une cavité 4 voisine.

Selon un mode de réalisation, l'orientation est telle qu'un angle entre la direction d'écoulement du flux d'air F et une direction d'une droite joignant deux sommets opposés de la base polygonale est compris entre -15° et 15°.

Selon un autre mode de réalisation, l'orientation est telle qu'un angle entre la direction d'écoulement du flux d'air F et une direction d'une droite joignant deux sommets opposés de la base polygonale est compris entre 75° et 105°, de préférence entre 75° et 90°.

De préférence, la surface d'échanges 2 est réalisée dans un matériau en alliage d'aluminium ou en plastique, en particulier un plastique conducteur thermique, par exemple constitué d'un mélange de polymère et de fibres conductrices thermiquement (graphite, métallique, céramique,...). Un tel matériau présente des propriétés thermiques anisotropes, la conductivité thermique étant différente suivant l'orientation des fibres du plastique thermo conducteur.

L'invention a également pour objet un procédé de fabrication du dissipateur thermique 1, comprenant une étape de moulage de la portion plane 3, et éventuellement une étape d'évidement de la portion plane 3, de sorte à former l'ensemble de cavités non débouchantes 4 affleurant la portion plane.

L'étape d'évidement est avantageusement réalisée par usinage de la surface de la portion plane.

On note que lors de l'étape de moulage de la portion plane 3, selon le matériau utilisé (matériau plastique anisotrope) le matériau s'oriente selon la forme du moule et les fibres orientées parallèlement aux parois du moule ont pour effet de réduire la conduction thermique du dissipateur 1. Grâce aux cavités 4 créées par évidement, la proportion des fibres mal orientées est réduite, augmentant de ce fait l'efficacité du dissipateur thermique.

## Revendications

1. Dissipateur thermique pour une carte électronique d'un groupe moto-ventilateur de véhicule automobile, comprenant une surface (2) destinée à échanger thermiquement avec un flux d'air (F) mis en mouvement par le groupe moto-ventilateur, dite surface d'échanges (2), ladite surface d'échanges (2) comprenant une portion plane (3) agencée pour que, dans une position installée dans le groupe moto-ventilateur, le flux d'air (F) mis en mouvement par le groupe moto-ventilateur s'écoule sensiblement parallèlement à ladite portion plane (3), la surface d'échanges (2) comprenant également un ensemble de cavités (4) non débouchantes affleurant ladite portion plane (3), **caractérisé en ce que** chaque cavité (4) comprend une partie en forme de pyramide tronquée à base hexagonale et/ou une partie de section constante.

2. Dissipateur thermique selon la revendication précédente, dans lequel les cavités (4) sont disposées selon un maillage de quadrilatère, par exemple rectangulaire et/ou en quinconce et/ou en nid d'abeille.

3. Dissipateur thermique selon l'une des revendications précédentes, dans lequel les cavités (4) possèdent une même orientation.

4. Dissipateur thermique selon l'une des revendications précédentes, dans lequel un rapport entre la profondeur d'une cavité (4) et la longueur d'un côté du polygone de la base est compris entre 0,05 et 0,5.

5. Dissipateur thermique selon l'une des revendications précédentes, dans lequel la surface d'échanges (2) est réalisée dans un matériau en alliage d'aluminium ou en plastique.

6. Procédé de fabrication d'un dissipateur thermique selon l'une des revendications précédentes, comprenant une étape de moulage de la portion plane (3), et une étape d'évidement de la portion plane (3), de sorte à former l'ensemble de cavités non débouchantes (4), affleurant la portion plane (3).

7. Groupe moto-ventilateur pour un véhicule automobile, comprenant un moteur, un ventilateur de mise en mouvement d'un flux d'air configuré pour être contrôlé par le moteur, et un module de commande dudit moteur, le module de commande comportant une carte électronique, le groupe moto-ventilateur comprenant également un dissipateur thermique selon l'une des revendications 1 à 5 agencé pour refroidir ladite carte électronique.

8. Groupe moto-ventilateur selon la revendication précédente, dans lequel les cavités du dissipateur thermique sont disposées en regard d'un composant électronique haute puissance de la carte électronique.

## Patentansprüche

1. Kühlkörper für eine Elektronikkarte einer Gebläseeinheit eines Kraftfahrzeugs, der eine Fläche (2) enthält, die dazu bestimmt ist, Wärme mit einem Luftstrom (F) auszutauschen, der von der Gebläseeinheit in Bewegung versetzt wird, Austauschfläche (2) genannt, wobei die Austauschfläche (2) einen ebenen Abschnitt (3) enthält, der eingerichtet ist, damit in einer in die Gebläseeinheit eingebauten Position der von der Gebläseeinheit in Bewegung versetzte Luftstrom (F) im Wesentlichen parallel zum ebenen Abschnitt (3) strömt, wobei die Austauschfläche (2) ebenfalls eine Einheit von nicht durchgehenden Hohlräumen (4) enthält, die am ebenen Abschnitt (3) bündig anliegen, **dadurch gekennzeichnet, dass** jeder Hohlraum (4) einen Teil in Form eines Pyramidenstumpfs mit sechseckiger Basis und/oder einen Teil mit konstantem Querschnitt enthält.

2. Kühlkörper nach dem vorhergehenden Anspruch, wobei die Hohlräume (4) gemäß einem Viereck-Gitternetz angeordnet sind, zum Beispiel rechtwinklig und/oder versetzt und/oder wabenförmig.

3. Kühlkörper nach einem der vorhergehenden Ansprüche, wobei die Hohlräume (4) eine gleiche Ausrichtung besitzen.

4. Kühlkörper nach einem der vorhergehenden Ansprüche, wobei ein Verhältnis zwischen der Tiefe eines Hohlraums (4) und der Länge einer Seite des Polygons der Basis zwischen 0,05 und 0,5 liegt.

5. Kühlkörper nach einem der vorhergehenden Ansprüche, wobei die Austauschfläche (2) aus einem Material aus Aluminiumlegierung oder aus Kunststoff hergestellt ist.

6. Herstellungsverfahren eines Kühlkörpers nach einem der vorhergehenden Ansprüche, das einen Schritt des Formens des ebenen Abschnitts (3) und einen Schritt des Aushöhlens des ebenen Abschnitts (3) enthält, um die Einheit von nicht durchgehenden Hohlräumen (4) zu formen, die am ebenen Abschnitt (3) bündig anliegen.

7. Gebläseeinheit für ein Kraftfahrzeug, das einen Motor, ein Gebläse, um einen Luftstrom in Bewegung zu versetzen, das konfiguriert ist, vom Motor gesteuert zu werden, und ein Steuermodul des Motors enthält, wobei das Steuermodul eine Elektronikkarte aufweist, wobei die Gebläseeinheit ebenfalls einen Kühlkörper nach einem der Ansprüche 1 bis 5 enthält, der eingerichtet ist, um die Elektronikkarte zu kühlen.

8. Gebläseeinheit nach dem vorhergehenden Anspruch, wobei die Hohlräume des Kühlkörpers gegenüber einem elektronischen Hochleistungsbauteil der Elektronikkarte angeordnet sind.

## Claims

1. Heat sink for an electronic board of a motor vehicle motor-driven fan unit, comprising a surface (2) intended to exchange heat with an air flow (F) set in motion by the motor-driven fan unit, known as exchange surface (2), said exchange surface (2) comprising a planar portion (3) arranged such that, in a position in which it is installed in the motor-driven fan unit, the air flow (F) set in motion by the motor-driven fan unit flows substantially parallel to said planar portion (3), the exchange surface (2) also comprising a collection of blind cavities (4) starting flush with said planar portion (3), **characterized in that** each cavity (4) comprises a part in the shape of a truncated hexagonal-base pyramid and/or a part of constant cross section.

2. Heat sink according to the preceding claim, wherein the cavities (4) are arranged in a quadrilateral, for example rectangular, grid pattern and/or in a staggered pattern and/or in a honeycomb pattern.

3. Heat sink according to one of the preceding claims, wherein the cavities (4) have the one same orientation.

4. Heat sink according to one of the preceding claims, wherein a ratio between the depth of a cavity (4) and the length of a side of the polygon constituting the base is comprised between 0.05 and 0.5.

5. Heat sink according to one of the preceding claims, wherein the exchange surface (2) is made from an aluminium alloy material or from a plastics material.

6. Method for manufacturing a heat sink according to one of the preceding claims, comprising a step of casting or moulding the planar portion (3) and a step of hollowing out the planar portion (3) so as to form the collection of blind cavities (4) starting flush with the planar portion (3).

7. Motor-driven fan unit for a motor vehicle, comprising a motor, a fan for setting in motion an air flow configured to be controlled by the motor, and a control module for said motor, the control module comprising an electronic board, the motor-driven fan unit also comprising a heat sink according to one of Claims 1 to 5 arranged in such a way as to cool said electronic board.

8. Motor-driven fan unit according to the preceding claim, wherein the cavities of the heat sink are positioned facing a high-power electronic component of the electronic board.
